# EUROPEAN PATENT APPLICATION

(11) **EP 4 556 272 A1**
(43) Date of publication of application: **21.05.2025**
(21) Application number: 24200887.8
(22) Date of filing: 17.09.2024
(51) Int. Cl.: B60K 1/00, B60K 1/02

(54) **ELECTRIC VEHICLE**

(30) Priority: 20.11.2023 JP 2023196991
(71) Applicant: TOYOTA JIDOSHA KABUSHIKI KAISHA, Aichi-ken, 471-8571 (JP)
(72) Inventor: ISHIBASHI, Masayuki, Aichi-ken, 471-8571 (JP); SUENAGA, Shinichiro, Aichi-ken, 471-8571 (JP); KUNIFUDA, Hiroki, Aichi-ken, 471-8571 (JP)
(74) Representative: D Young & Co LLP

(57) **Abstract**

An electric vehicle (10;300) includes: an electric motor (MG1,MG2;MGA); an engine (12;302); a power transmission device (16;304); a drive casing (100;340) that houses a drive apparatus (92;332) including the electric motor (MG1,MG2;MGA) and the power transmission device (16;304); a first electrical casing (102;342); and a second electrical casing (104;344). The drive casing (100;340), the first electrical casing (102;342) and the second electrical casing (104;344) cooperate to constitute a mechanical-electrical integrated unit (90;330). The drive casing (100;340) has a first wall surface (100a;340a), a second wall surface (100b;340b), a third wall surface (100c;340c), a fourth wall surface (100d;340d), a fifth wall surface (100e;340e) and a sixth wall surface (100f;340f). The engine (12;302) is disposed on the first wall surface (100a;340a), and is connected to an input shaft (22;308) of the power transmission device (16;304) on a side of the first wall surface (100a;340a). The first electrical casing (102;342) and the second electrical casing (104;344) are separately disposed on respective two of the second wall surface (100b;340b), the third wall surface (100c;340c), the fourth wall surface (100d;340d), the fifth wall surface (100e;340e) and the sixth wall surface (100f;340f).

## Description

### FIELD OF THE INVENTION

The present invention relates to an electric vehicle including a mechanical-electrical integrated unit.

### BACKGROUND OF THE INVENTION

There is well known an electric vehicle including: an electric motor; a power transmission device to which the electric motor is connected in a power transmittable manner; first electrical equipment; second electrical equipment; a drive casing that houses a drive apparatus including the electric motor and the power transmission device; a first electrical casing that houses the first electrical equipment; and a second electrical casing that houses the second electrical equipment, wherein the drive casing, the first electrical casing and the second electrical casing are integrally arranged, and cooperate to constitute a mechanical-electrical integrated unit. For example, JP 2022-152851 A discloses such a vehicle including an in-vehicle unit as the mechanical-electrical integrated unit. In the vehicle disclosed in this Japanese Patent Application Publication, the mechanical-electrical integrated unit has a laminated structure in which the drive casing, the first electrical casing and the second electrical casing are arranged in this order of description in a vertical direction of the vehicle.

### SUMMARY OF THE INVENTION

By the way, where the mechanical-electrical integrated unit having the laminated structure is installed in a vehicle, a degree of freedom in installing the mechanical-electrical integrated unit could be reduced depending on an installation space or components of the mechanical-electrical integrated unit. On the other hand, it might be possible to dispose one of the first and second electrical casings on an upper side of the drive casing in a vertical direction of the vehicle and to dispose the other of the first and second electrical casings on one of opposite sides of the drive casing that are opposite to each other in a horizontal direction of the vehicle. However, depending on arrangement of the two electrical casings, the first electrical equipment and/or the second electrical equipment could receive heat from a main power source such as an engine or electric motor, so that there is a risk that a cooling performance of the mechanical-electrical integrated unit could be reduced.

The present invention was made in view of the background art described above. It is therefore an object of the present invention to provide an electric vehicle capable of suppressing reduction of a cooling performance while increasing a degree of freedom in installing a mechanical-electrical integrated unit.

The object indicated above is achieved according to the following aspects of the present invention.

According to a first aspect of the invention, there is provided an electric vehicle including: an electric motor; an engine; a power transmission device to which each of the electric motor and the engine is connected in a power transmittable manner; first electrical equipment; second electrical equipment; a drive casing that houses a drive apparatus including the electric motor and the power transmission device; a first electrical casing that houses the first electrical equipment; and a second electrical casing that houses the second electrical equipment. The drive casing, the first electrical casing and the second electrical casing are integrally arranged, and cooperate to constitute a mechanical-electrical integrated unit. The drive casing has a first wall surface, a second wall surface, a third wall surface, a fourth wall surface, a fifth wall surface and a sixth wall surface that cooperate to define a space in which the drive apparatus is housed. The engine is disposed on the first wall surface, and is connected to an input shaft of the power transmission device on a side of the first wall surface. The first electrical casing and the second electrical casing are separately disposed on respective two of the second wall surface, the third wall surface, the fourth wall surface, the fifth wall surface and the sixth wall surface.

According to a second aspect of the invention, in the electric vehicle according to the first aspect of the invention, the engine is disposed on one of opposite sides of the drive casing which are opposite to each other in a horizontal direction of the electric vehicle, one of the first electrical casing and the second electrical casing is disposed on the other of the opposite sides of the drive casing in the horizontal direction, and the other of the first electrical casing and the second electrical casing is disposed on an upper side of the drive casing in a vertical direction of the electric vehicle.

According to a third aspect of the invention, there is provided an electric vehicle including: an electric motor; a power transmission device to which the electric motor is connected in a power transmittable manner; first electrical equipment; second electrical equipment; a drive casing that houses a drive apparatus including the electric motor and the power transmission device; a first electrical casing that houses the first electrical equipment; and a second electrical casing that houses the second electrical equipment. The drive casing, the first electrical casing and the second electrical casing are integrally arranged, and cooperate to constitute a mechanical-electrical integrated unit. The drive casing has a first wall surface, a second wall surface, a third wall surface, a fourth wall surface, a fifth wall surface and a sixth wall surface that cooperate to define a space in which the drive apparatus is housed. The first wall surface is located on one of both sides of the power transmission device which is remote from the electric motor. The second wall surface is located on the other of the both sides of the power transmission device which is a side of the electric motor. One of the first electrical casing and the second electrical casing is disposed on the first wall surface. The other of the first electrical casing and the second electrical casing is disposed on one of the third wall surface, the fourth wall surface, the fifth wall surface and the sixth wall surface.

According to a fourth aspect of the invention, in the electric vehicle according to the third aspect of the invention, the one of the first electrical casing and the second electrical casing is disposed on one of opposite sides of the drive casing which are opposite to each other in a horizontal direction of the electric vehicle, and the other of the first electrical casing and the second electrical casing is disposed on an upper side of the drive casing in a vertical direction of the electric vehicle.

According to a fifth aspect of the invention, in the electric vehicle according to any one of the first through fourth aspects of the invention, there is further provided a high-voltage battery and a low-voltage battery, wherein the first electrical equipment includes an inverter that is configured to convert a DC power supplied from the high-voltage battery, into an AC power that is to be supplied to the electric motor, and the second electrical equipment includes a DC-DC converter that is configured to lower a voltage of the high-voltage battery to charge the low-voltage battery.

According to a sixth aspect of the invention, in the electric vehicle according to the fifth aspect of the invention, the second electrical equipment further include a reactor included in a boost converter that is configured to boost the DC power supplied from the high-voltage battery and to supply the boosted DC power to the inverter.

According to a seventh aspect of the invention, in the electric vehicle according to the fifth aspect of the invention, there is further provided a charger that is configured to charge the high-voltage battery with an electric power supplied from an external power source, wherein the charger is housed in one of the first electrical casing and the second electrical casing.

According to an eighth aspect of the invention, in the electric vehicle according to the fifth aspect of the invention, there is further provided a current sensor configured to detect an electric current of the electric motor, wherein the first electrical equipment further includes an electric-motor control device configured to control the inverter, and the current sensor is configured to supply a signal indicative of the detected electric current of the electric motor, to the electric-motor control device, and is housed in the first electrical casing.

According to a ninth aspect of the invention, in the electric vehicle according to the fifth aspect of the invention, there is further provided a resolver configured to detect a rotational speed of the electric motor, wherein the first electrical equipment further includes an electric-motor control device configured to control the inverter, the resolver is configured to supply a signal indicative of the detected rotational speed of the electric motor, to the electric-motor control device, and is disposed in the electric motor housed in the drive casing, and the electric-motor control device and the resolver are electrically connected through a wire that is disposed only within the drive casing and the first electrical casing.

According to a tenth aspect of the invention, in the electric vehicle according to the fifth aspect of the invention, there is further provided a current sensor configured to detect an electric current of the electric motor, and a resolver configured to detect a rotational speed of the electric motor, wherein the first electrical equipment further includes an electric-motor control device configured to control the inverter, the current sensor is configured to supply a signal indicative of the detected electric current of the electric motor, to the electric-motor control device, and is housed in the first electrical casing, the resolver is configured to supply a signal indicative of the detected rotational speed of the electric motor, to the electric-motor control device, and is disposed in the electric motor housed in the drive casing, the resolver is located on one of opposite sides of the electric motor that are opposite to each other in a direction parallel to an axis of the electric motor, and the current sensor is located on the other of the opposite sides of the electric motor in the direction parallel to the axis of the electric motor.

In the electric vehicle according to the first aspect of the invention, the engine is disposed on the first wall surface, and is connected to the input shaft of the power transmission device on a side of the first wall surface. Further, the first electrical casing and the second electrical casing are separately disposed on respective two of the second wall surface, the third wall surface, the fourth wall surface, the fifth wall surface and the sixth wall surface. Owing to the arrangements, it is easy to install the mechanical-electrical integrated unit in the electric vehicle, since the first electrical casing and the second electrical casing are arranged separately. Further, since the first electrical casing and second electrical casing are located to be distant from the engine, the first electrical equipment and second electrical equipment are restricted from receiving heat from the engine. This allows for greater freedom in installing the mechanical-electrical integrated unit while preventing deterioration of cooling performance.

In the electric vehicle according to the second aspect of the invention, when being installed in the electric vehicle, the engine is disposed on one of the opposite sides of the drive casing which are opposite to each other in the horizontal direction of the electric vehicle. Further, one of the first electrical casing and the second electrical casing is disposed on the other of the opposite sides of the drive casing in the horizontal direction, and the other of the first electrical casing and the second electrical casing is disposed on the upper side of the drive casing in the vertical direction of the electric vehicle. Owing to the arrangements, it is easy to appropriately install the mechanical-electrical integrated unit in the electric vehicle, and it is possible to appropriately restrict the first electrical equipment and the second electrical equipment from receiving the heat from the engine.

In the electric vehicle according to the third aspect of the invention, one of the first electrical casing and the second electrical casing is disposed on the first wall surface that is located on one of the both sides of the power transmission device which is remote from the electric motor. Further, the other of the first electrical casing and the second electrical casing is disposed on one of four wall surfaces which are the third wall surface, the fourth wall surface, the fifth wall surface and the sixth wall surface, and which other than the second wall surface that is located on one of the both sides of the power transmission device which is a side of the electric motor. Owing to the arrangements, it is easy to install the mechanical-electrical integrated unit in the electric vehicle, since the first electrical casing and the second electrical casing are arranged separately. Further, since the first electrical casing and second electrical casing are located to be distant from the electric motor, the first electrical equipment and second electrical equipment are restricted from receiving heat from the electric motor. This allows for greater freedom in installing the mechanical-electrical integrated unit while preventing deterioration of cooling performance.

In the electric vehicle according to the fourth aspect of the invention, when being installed in the electric vehicle, the one of the first electrical casing and the second electrical casing is disposed on one of the opposite sides of the drive casing which are opposite to each other in the horizontal direction of the electric vehicle, and the other of the first electrical casing and the second electrical casing is disposed on the upper side of the drive casing in the vertical direction of the electric vehicle. Owing to the arrangements, it is easy to appropriately install the mechanical-electrical integrated unit in the electric vehicle, and it is possible to appropriately restrict the first electrical equipment and the second electrical equipment from receiving the heat from the electric motor.

In the electric vehicle according to the fifth aspect of the invention, the first electrical equipment includes the inverter that is configured to convert the DC power supplied from the high-voltage battery, into the AC power that is to be supplied to the electric motor, and the second electrical equipment includes the DC-DC converter that is configured to lower the voltage of the high-voltage battery to charge the low-voltage battery. Owing to the arrangements, the inverter and the DC-DC converter are disposed separately, so that the electric motor and the inverter can be easily connected to each other, and maintenance performance of the DC-DC converter can be improved.

In the electric vehicle according to the sixth aspect of the invention, the second electrical equipment further include the reactor included in the boost converter that is configured to boost the DC power supplied from the high-voltage battery and to supply the boosted DC power to the inverter. Owing to the arrangement, the inverter and the reactor are disposed separately, so that maintenance performance of the reactor can be improved.

In the electric vehicle according to the seventh aspect of the invention, the charger, which is configured to charge the high-voltage battery with the electric power supplied from the external power source, is housed in one of the first electrical casing and the second electrical casing. Owing to the arrangement, it is possible to effectively use installation space.

In the electric vehicle according to the eighth aspect of the invention, the first electrical equipment further includes the electric-motor control device configured to control the inverter, and the current sensor, which is configured to detect the electric current of the electric motor and to supply the signal indicative of the detected electric current, to the electric-motor control device, is housed in the first electrical casing. Owing to the arrangements, the current sensor and the electric-motor control device can be connected directly to each other, and the current sensor and the electric motor can be connected directly to each other, thereby making it possible to eliminate a terminal block and to suppress cost of the mechanical-electrical integrated unit.

In the electric vehicle according to the ninth aspect of the invention, the first electrical equipment further includes the electric-motor control device configured to control the inverter, and the resolver, which is configured to detect the rotational speed of the electric motor and to supply the signal indicative of the detected rotational speed of the electric motor, to the electric-motor control device, is disposed in the electric motor housed in the drive casing. Further, the electric-motor control device and the resolver are electrically connected through the wire that is disposed only within the drive casing and the first electrical casing. Owing to the arrangements, the cost of the mechanical-electrical integrated unit can be reduced because length of the wire that transmits the detection signal from the resolver can be shortened as compared to an arrangement in which the wire is routed outside the drive casing.

In the electric vehicle according to the tenth aspect of the invention, the first electrical equipment further includes the electric-motor control device configured to control the inverter. Further, the current sensor, which is configured to detect the electric current of the electric motor and to supply the signal indicative of the detected electric current, to the electric-motor control device, is housed in the first electrical casing, and the resolver, which is configured to detect the rotational speed of the electric motor and to supply the signal indicative of the detected rotational speed, to the electric-motor control device, is disposed in the electric motor housed in the drive casing. Further, the resolver is located on one of the opposite sides of the electric motor that are opposite to each other in the direction parallel to the axis of the electric motor, and the current sensor is located on the other of the opposite sides of the electric motor in the direction parallel to the axis of the electric motor. Owing to the arrangements, the current sensor and the electric-motor control device can be connected directly to each other, and the current sensor and the electric motor can be connected directly to each other. Further, the wire electrically connecting between the electric-motor control device and the resolver can be easily disposed only within the drive casing and within the first electrical casing.

### BRIEF DESCRIPTION OF THE DRAWINGS

FIG 1 is a view showing, by way of example, a construction of an electric vehicle to which the present invention is applied, wherein the electric vehicle is constructed according to a first embodiment of the present invention;
FIG.2 is a view showing, by way of example, an electrical configuration for controlling first and second electric motors in the electric vehicle shown in FIG 1;
FIG.3 is a view showing, by way of example, a construction of a mechanical-electrical integrated unit in the electric vehicle shown in FIG 1;
FIG.4 is another view showing, by way of example, the construction of the mechanical-electrical integrated unit;
FIG.5 is a view showing, by way of examples, positions of respective components of the mechanical-electrical integrated unit;
FIG.6 is a view showing, by way of examples, positions of respective casings of the mechanical-electrical integrated unit;
FIG.7 is a view showing, by way of examples, positions of respective components of the mechanical-electrical integrated unit, wherein the positions of the respective components are different from those shown in FIG. 5;
FIG.8 is a view showing, by way of example, a state in which the mechanical-electrical integrated unit is installed in the electric vehicle;
FIG.9 is a view showing, by way of example, a construction of an electric vehicle to which the present invention is applied, wherein the electric vehicle is constructed according to a second embodiment of the present invention;
FIG. 10 is a view showing, by way of example, an electrical configuration for controlling an electric motor in the electric vehicle shown in FIG.9;
FIG. 11 is a view showing, by way of examples, positions of respective casings of a mechanical-electrical integrated unit in the electric vehicle shown in FIG.9;
FIG. 12 is a view showing, by way of examples, positions of respective components of the mechanical-electrical integrated unit, wherein the positions of the respective components are different from those shown in FIG. 11; and
FIG. 13 is a view showing, by way of example, a construction of an electric vehicle to which the present invention is applied, wherein the electric vehicle is constructed according to a third embodiment of the present invention.

### DETAILED DESCRIPTION OF PREFERRED EMBODIMENT

In an embodiment of the present invention, the mechanical-electrical integrated unit is, in a broad sense, a casing housing the drive apparatus including the electric motor and the power transmission device, and a casing housing the electric power control device are integrated into the case, i.e., arranged in close proximity. For example, the mechanical-electrical integrated unit may have a configuration in which the casing of the electric power control device and the casing of the drive apparatus are fixed to each other through bolts or brackets, or the electric power control device is housed in the casing of the drive apparatus. Specifically, the mechanical-electrical integrated unit may have a configuration in which the casing housing the electric power control device and the casing housing the drive apparatus are separated from each other, and the casings are fastened to each other through brackets or bolts. Alternatively, the mechanical-electrical integrated unit may have a configuration in which the casing housing the electric motor also houses the electric power control device, or the casing housing the electric motor and the power transmission device also houses electric power control device.

Hereinafter, embodiments of the invention will be described in detail with reference to the accompanying drawings.

### FIRST EMBODIMENT

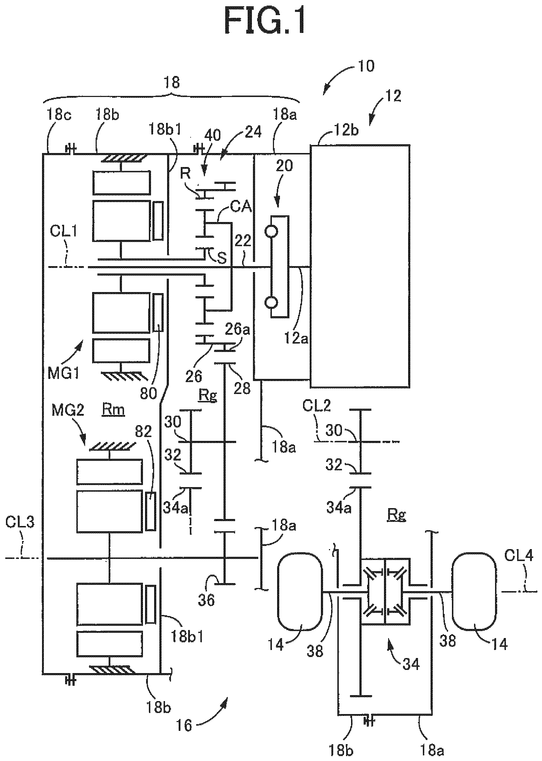

FIG 1 is a view showing, by way of example, a construction of an electric vehicle 10 to which the present invention is applied, wherein the electric vehicle 10 is constructed according to a first embodiment of the present invention. As shown in FIG. 1, the electric vehicle 10 is a hybrid electric vehicle including an engine 12, a first electric motor MG1 and a second electric motor MG2. The electric vehicle 10 (hereinafter simply referred to as "vehicle 10") includes drive wheels 14 and a power transmission device 16.

The engine 12 is a known internal combustion engine. The power transmission device 16 is provided in a power transmission path between the engine 12 and the drive wheels 14 and a power transmission path between the second electric motor MG2 and the drive wheels 14. The engine 12 is a power source (e.g., main power source) that is connected to the power transmission device 16 in a power transmittable manner. The second electric motor MG2 is an electric motor functioning as a power source (e.g., auxiliary power source)

The first electric motor MG1 and the second electric motor MG2 are known rotary electric machines, so-called motor generators, each having a function as a motor that generates a mechanical power from an electric power and a function as a power generator that generates an electric power from a mechanical power. The first electric motor MG1 and the second electric motor MG2 are provided in a non-rotatable casing 18 which is a non-rotatable member attached to a body of the vehicle 10.

The power transmission device 16 includes a damper 20, an input shaft 22, a transmission portion 24, a composite gear 26, a driven gear 28, a driven shaft 30, a final gear 32, a differential gear device 34 and a reduction gear 36 that are housed in the casing 18. The power transmission device 16 includes a pair of drive shafts 38 connected to the differential gear device 34.

The damper 20 is connected to a crankshaft 12a of the engine 12. The input shaft 22 functions as an input rotary member of the transmission portion 24. The input shaft 22 is connected to the damper 20, and is connected to the crankshaft 12a via the damper 20 and the like. The transmission portion 24 is connected to the input shaft 22. The composite gear 26 is a rotary body on an output side of the transmission portion 24. The composite gear 26 has a drive gear 26a formed on a part of an outer peripheral surface thereof. The drive gear 26a is an output-side rotary member of the transmission portion 24. The driven gear 28 meshes with the drive gear 26a. The driven gear 28 and the final gear 32 are fixed onto the driven shaft 30 so as not to be relatively rotatable. The final gear 32 has a smaller diameter than the driven gear 28 and meshes with a differential ring gear 34a of the differential gear device 34. The reduction gear 36 has a smaller diameter than the driven gear 28 and meshes with the driven gear 28. A rotor shaft of the second electric motor MG2 is connected to the reduction gear 36, so that the second electric motor MG2 is connected to the reduction gear 36 in a power transmittable manner.

The power transmission device 16 constructed as described above is suitably used for a vehicle of a front engine front drive (FF) type or a rear engine rear drive (RR) type. The power transmission device 16 transmits a power outputted from the engine 12 to the driven gear 28 via the transmission portion 24. The power transmission device 16 transmits a power outputted from the second electric motor MG2 to the driven gear 28 via the reduction gear 36. The power transmission device 16 transmits the power transmitted to the driven gear 28 to the drive wheels 14 sequentially via the driven shaft 30, the final gear 32, the differential gear device 34, the drive shafts 38 and the like. The driven gear 28, the driven shaft 30, and the final gear 32 constitute a transmission mechanism that transmits the power from the second electric motor MG2 to the drive gear 26a. The differential gear device 34 distributes the power from the engine 12 and the second electric motor MG2 to the drive wheels 14. The drive shafts 38 transmit the power from the differential gear device 34 to the drive wheels 14. The second electric motor MG2 is connected to the drive wheels 14 in a power transmittable manner.

The transmission portion 24 includes the first electric motor MG1 and a differential mechanism 40. The differential mechanism 40 is a known single-pinion planetary gear device including a sun gear S, a carrier CA and a ring gear R. The sun gear S is connected to the rotor shaft of the first electric motor MG1, so that the first electric motor MG1 is connected to the sun gear S in a power transmittable manner. The carrier CA is connected to the input shaft 22, such that the engine 12 is connected to the carrier CA via the input shaft 22 and the like in a power transmittable manner. The ring gear R is formed on a part of an inner peripheral surface of the composite gear 26, and is integrally connected to the drive gear 26a.

The differential mechanism 40 functions as a differential mechanism which is connected to the engine 12 in a power transmittable manner and which generates a differential action. The first electric motor MG1 is an electric motor that is connected to the differential mechanism 40 in a power transmittable manner. The differential mechanism 40 is a power split mechanism that mechanically splits the power of the engine 12 (that is inputted to the carrier CA) to the first electric motor MG1 and the drive gear 26a. The transmission portion 24 is a known electric transmission mechanism in which a differential state of the differential mechanism 40 is controlled with an operation state of the first electric motor MG1 being controlled.

The power transmission device 16 has a first axis CL1, a second axis CL2, a third axis CL3 and a fourth axis CL4. These four axes CL1, CL2, CL3, CL4 are parallel to one another. The first axis CL1 is an axis of each of the input shaft 22 and the rotor shaft of the first electric motor MG1, and is a rotation axis of each of the transmission portion 24 and the first electric motor MG1. The second axis CL2 is an axis of the driven shaft 30, and is a rotation axis of each of the driven gear 28 and the final gear 32. The third axis CL3 is an axis of a rotor shaft of the second electric motor MG2, and is a rotation axis of each of the reduction gear 36 and the second electric motor MG2. The fourth axis CL4 is an axis of each of the drive shafts 38, and is a rotation axis of the differential gear device 34.

The casing 18 includes a housing 18a, a main body 18b and a cover 18c. The housing 18a includes an opening portion on a side of the engine 12. The engine 12 includes an engine block 12b that is connected to the opening portion of the housing 18a. The housing 18a includes another opening portion that is remote from the engine 12. The housing 18a and the main body 18b are integrally connected by fasteners such as bolts such that the another opening portion of the housing 18a and an opening portion of the main body 18b, which are opposed to each other, are aligned with each other. The main body 18b and the cover 18c are integrally connected by fasteners such as bolts such that the cover 18c closes another opening portion of the main body 18b that is remote from the engine 12.

The main body 18b is a casing including a partition wall 18b1 that separates a gear room Rg and a motor room Rm from each other, wherein the gear room Rg houses the driven gear 28, the deferential gear device 34, the differential mechanism 40 and the like, while the motor room Rm houses the first electric motor MG1 and the second electric motor MG2. The main body 18b cooperates with the housing 18a to form the gear room Rg. The main body 18b cooperates with the partition wall 18b1 and the cover 18c to form the motor room Rm that is located between the partition wall 18b1 and the cover 18c.

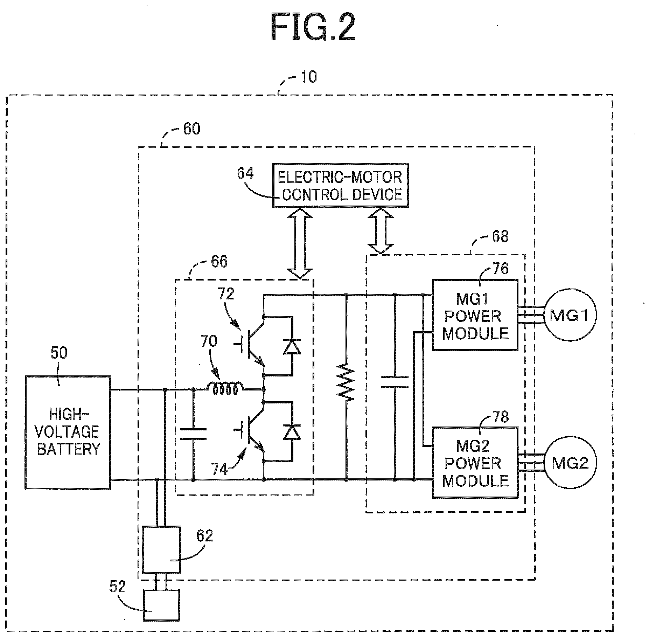

FIG. 2 is a view showing, by way of example, an electrical configuration related to control of the first and second electric motors MG1, MG2, for example. As shown in FIG 2, the vehicle 10 further includes a high-voltage battery 50, an auxiliary battery 52 and an electric-power control unit 60.

The high-voltage battery 50 is a chargeable and dischargeable DC power supply, and is a secondary battery such as a nickel-hydrogen secondary battery or a lithium ion battery. The high-voltage battery 50 is connected to the electric-power control unit 60. The stored electric power is supplied from the high-voltage battery 50 to, for example, the second electric motor MG2 via the electric-power control unit 60. The high-voltage battery 50 is supplied with the electric power generated by the first electric motor MG1 and the electric power regenerated by the second electric motor MG2 via the electric-power control unit 60. The high-voltage battery 50 is a driving battery.

The electric-power control unit 60 includes a DC-DC converter 62, an electric-motor control device 64, a boost converter 66 and an inverter 68. The electric-power control unit 60 is an electric-power control apparatus that controls the electric power transmitted and received between the high-voltage battery 50 and each of the first electric motor MG1 and the second electric motor MG2.

The DC-DC converter 62 is connected to the high-voltage battery 50. The DC-DC converter 62 functions as a charging device that reduces a voltage of the high-voltage battery 50 to a voltage equivalent to a voltage of the auxiliary battery 52, and charges the auxiliary battery 52. The auxiliary battery 52 is a low-voltage battery that supplies the electric power for operating auxiliary devices, the electric-motor control device 64 and the like, which are provided in the vehicle 10.

The boost converter 66 includes a reactor 70 and two switching elements 72, 74. The boost converter 66 is a step-up/down circuit having a function of boosting the voltage of the high-voltage battery 50 and supplying the boosted voltage to the inverter 68, and a function of reducing the voltage converted into a direct current by the inverter 68 and supplying the reduced voltage to the high-voltage battery 50. Thus, the boost converter 66 boosts the DC power from the high-voltage battery 50 and supplies the boosted power to the inverter 68.

The inverter 68 includes an MG1 power module 76 and an MG2 power module 78. Each of the MG1 power module 76 and the MG2 power module 78 includes switching elements that are similar to the switching elements 72, 74. The inverter 68 converts the DC current supplied from the boost converter 66, into the AC current for driving the first electric motor MG1 and the second electric motor MG2. Thus, the inverter 68 converts the DC power supplied from the high-voltage battery 50 and boosted by the boost converter 66, into the AC power, and then supplies the AC power to the first electric motor MG1 and the second electric motor MG2. The inverter 68 converts the AC current that is generated in the first electric motor MG1 by the power of the engine 12 and the AC current that is generated in the second electric motor MG2 by regenerative braking, into the DC current. The inverter 68 supplies the AC current generated in the first electric motor MG1, to supply as a driving electric power for driving the second electric motor MG2, depending on a running state of the vehicle 10.

The electric-motor control device 64 controls the boost converter 66 and the inverter 68, and controls the first electric motor MG1 and the second electric motor MG2. For example, the electric-motor control device 64 converts the DC current supplied from the high-voltage battery 50, into the AC current used for the first electric motor MG1 and the second electric motor MG2. The electric-motor control device 64 drives the first electric motor MG1, for supplying the electric power to the second electric motor MG2 and for obtaining the electric power required to charge the high-voltage battery 50. The electric-motor control device 64 drives the second electric motor MG2 based on a power demand value corresponding to a torque demanded by a driver of the vehicle 10. The electric-motor control device 64 causes the second electric motor MG2 to function as the power generator in accordance with the required amount of regenerative braking.

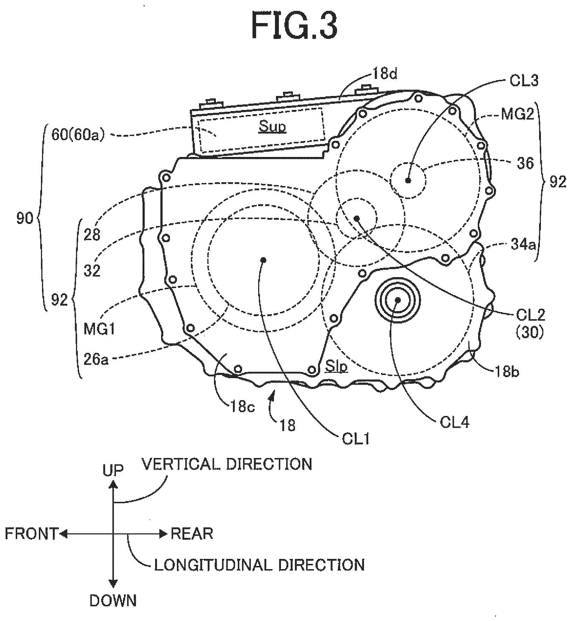

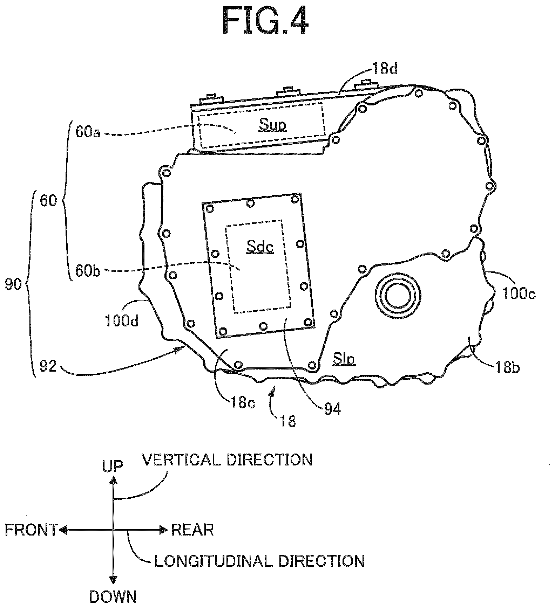

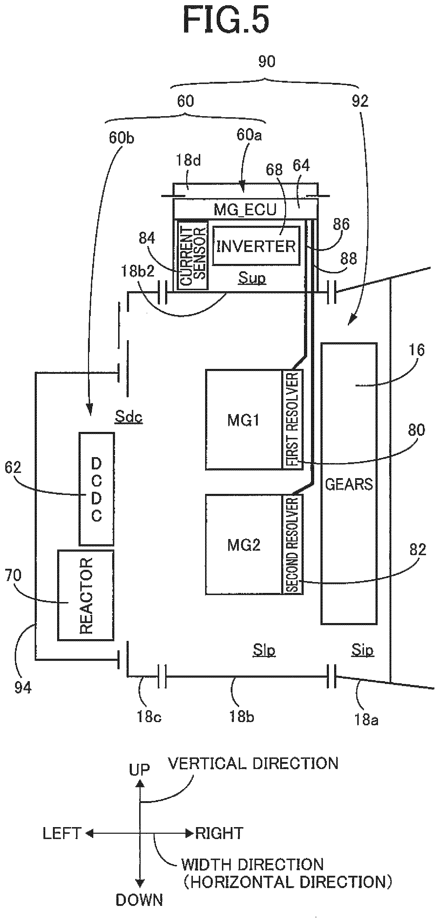

FIGS.3, 4 and 5 are view for explaining an example of a construction of a mechanical-electrical integrated unit 90. FIGS.3 and 4 are views as seen from a left side of the vehicle 10. FIG. 5 is a view as seen from a rear side of the vehicle 10, showing positions of respective components of the mechanical-electrical integrated unit 90. It is noted that "VERTICAL DIRECTION", "LONGITUDINAL DIRECTION" and "WIDTH DIRECTION" in the drawings indicate directions in the vehicle 10. The "WIDTH DIRECTION" is a horizontal direction parallel to an axial direction corresponding to each of the first axis CL1, the second axis CL2, the third axis CL3 and the fourth axis CL4. The left and right in the "WIDTH DIRECTION" are left and right in relation to the "LONGITUDINAL DIRECTION".

As shown in FIGS.3, 4 and 5, the mechanical-electrical integrated unit 90 is constituted by the drive apparatus 92 and the electric-power control unit 60 that are integrally arranged. The drive apparatus 92 is a transaxle that includes the power transmission device 16 (26a, 28, 32, 34a, 36 etc.), the first electric motor MG1 and the second electric motor MG2, wherein the power transmission device 16 includes the drive gear 26a, the driven gear 28, the final gear 32, the differential ring gear 34a and the reduction gear 36. The electric-power control unit 60 is sectioned into a first electrical equipment 60a and a second electrical equipment 60b. The first electrical equipment 60a includes the electric-motor control device 64 (see "MG_ECU" in FIG. 5) and the inverter 68, for example. The second electrical equipment 60b includes the DC-DC converter 62 and the reactor 70, for example.

The casing 18 further includes a protection plate 18d in addition to the above-described housing 18a, main body 18b and cover 18c. The main body 18b includes a bottom wall and side walls that extend upward in the vertical direction from an outer peripheral edge of the bottom wall on front and rear sides in the longitudinal direction of the vehicle 10, and opens in its upper portion in the vertical direction of the vehicle 10. The protection plate 18d is a plate-shaped member that closes an opening in the upper portion of the main body 18b. The main body 18b has a partition wall 18b2 (see FIG.5), such that an inner space of the main body 18b is divided into two spaces by the partition wall 18b2, wherein the two spaces are a lower space Slp as a lower portion of the inner space of the main body 18b in the vertical direction and an upper space Sup as an upper portion of the inner space of the main body 18b in the vertical direction.

The vehicle 10 is provided with a DC-DC plate 94 to which the second electrical equipment 60b is fixed. The DC-DC plate 94 is attached to an opening of the cover 18c, which is opposite to the main body 18b, so that a DC-DC space Sdc is defined in the cover 18c.

When being installed in the vehicle 10, the drive apparatus 92 is housed in the lower space Slp of the main body 18b and the inner space Sip of the housing 18a. When being installed in the vehicle 10, the first electrical equipment 60a is housed in the upper space Sup of the main body 18b. When being installed in the vehicle 10, the second electrical equipment 60b is housed in the DC-DC space Sdc of the cover 18c.

Referring to FIG. 3, the drive apparatus 92 is disposed such that the first axis CL1, the second axis CL2, the third axis CL3 and the fourth axis CL4 are parallel to a horizonal direction perpendicular to the longitudinal direction of the vehicle 10. Further, the first axis CL1, the second axis CL2, the third axis CL3 and the fourth axis CL4 are located relative to one another, such that the second electric motor MG2, the driven shaft 30, the first electric motor MG1 and the differential gear device 34 are arranged in this order of description from above to below in the vertical direction, and such that the first electric motor MG1, the driven shaft 30, the differential gear device 34 and the second electric motor MG2 are arranged in this order of description from front to rear in the longitudinal direction. Thus, a vertical size of the drive apparatus 92 in the vertical direction is reduced while distances among the first axis CL1, the second axis CL2, the third axis CL3 and the fourth axis CL4 are appropriately ensured. Therefore, the upper space Sup is created in an upper portion of the drive apparatus 92 in the vertical direction of the vehicle 10.

The first electrical equipment 60a, which is a part of the electric-power control unit 60, is disposed in a space created by reduction of the vertical size of the drive apparatus 92. The second electrical equipment 60b, which is another part of the electric-power control unit 60, is disposed in the DC-DC space Sdc that is located on one of opposite sides of the drive apparatus 92 that are opposite to each other in the horizontal direction. Since the electric-power control unit 60 is divided into the first electrical equipment 60a and the second electrical equipment 60b, a vertical size of the mechanical-electrical integrated unit 90 in the vertical direction is reduced.

As shown in FIG.5, the vehicle 10 further includes a first resolver 80, a second resolver 82, a current sensor 84, a first wire 86 and a second wire 88. The first resolver 80 is provided for the first electric motor MG1, and is located in the motor room Rm (see FIG. 1). The first wire 86 is a wire that electrically connects between the electric-motor control device 64 and the first resolver 80. The first resolver 80 detects a rotational speed of the first electric motor MG1, and supplies a signal indicative of the detected rotational speed, to the electric-motor control device 64. The second resolver 82 is provided for the second electric motor MG2, and is located in the motor room Rm (see FIG. 1). The second wire 88 is a wire that electrically connects between the electric-motor control device 64 and the second resolver 82. The second resolver 82 detects a rotational speed of the second electric motor MG2, and supplies a signal indicative of the detected rotational speed, to the electric-motor control device 64. The current sensor 84 detects an electric current of each of the first and second electric motors MG1, MG2, and supplies a signal indicative of the detected electric current, to the electric-motor control device 64.

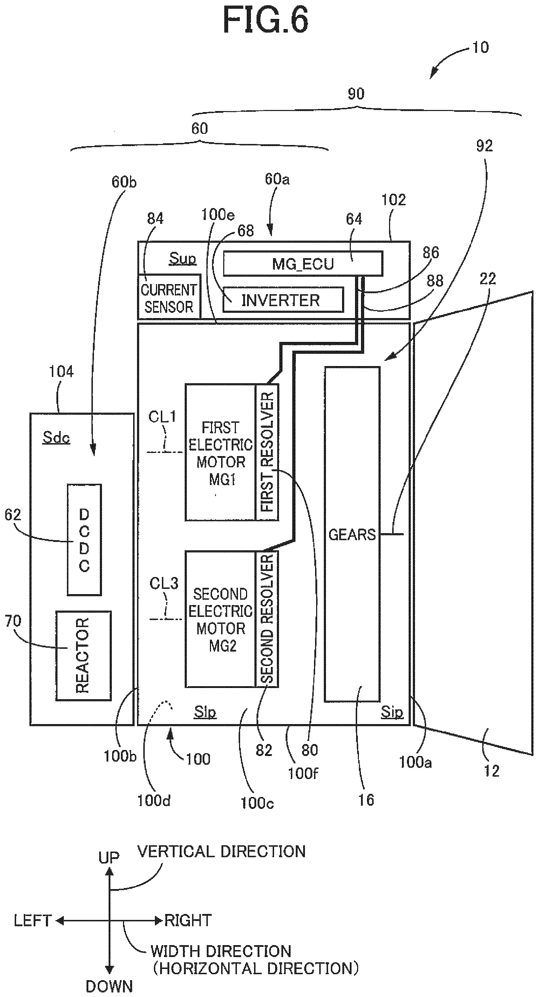

FIG.6 is a view showing, by way of examples, positions of the respective casings of the mechanical-electrical integrated unit 90, as seen from a rear side of the vehicle 10. As seen in FIG.6, the vehicle 10 includes a drive casing 100, a first electrical casing 102 and a second electrical casing 104.

The drive casing 100 is a casing having a space that houses the drive apparatus 92, namely, a casing having the lower space Slp of the main body 18b and the inner space Sip of the housing 18a. The first electrical casing 102 is a casing having a space that houses the first electrical equipment 60a, namely, a casing having the upper space Sup of the main body 18b. The second electrical casing 104 is a casing having a space that houses the second electrical equipment 60b, namely, a casing having the DC-DC space Sdc of the cover 18c. The mechanical-electrical integrated unit 90 is a unit in which the drive casing 100, the first electrical casing 102 and the second electrical casing 104 are integrally arranged. The casing 18 can be regarded to be constituted by the drive casing 100, the first electrical casing 102 and the second electrical casing 104 that are integrally arranged.

The drive casing 100 has a first wall surface 100a, a second wall surface 100b, a third wall surface 100c, a fourth wall surface 100d (see FIG4), a fifth wall surface 100e and a sixth wall surface 100f that cooperate to define a space that houses the drive apparatus 92. The first wall surface 100a is a right-side wall surface in the width direction of the vehicle 10, and is a wall surface of the housing 18a on which the engine 12 is disposed. The engine 12 is connected to the input shaft 22 on a side of the first wall surface 100a. The second wall surface 100b is a left-side wall surface in the width direction of the vehicle 10, and is a wall surface of the main body 18b to which the cover 18c is connected. The second wall surface 100b is a wall surface opposed to the first wall surface 100a. The third wall surface 100c is a rear-side wall surface in the longitudinal direction of the vehicle 10. The fourth wall surface 100d is a front-side wall surface (see FIG.4) in the longitudinal direction of the vehicle 10. The fourth wall surface 100d is a wall surface opposed to the third wall surface 100c. The fifth wall surface 100e is an upper-side wall surface in the vertical direction of the vehicle 10. The fifth wall surface 100e is a wall surface corresponding to the partition wall 18b2 (see FIGS). The sixth wall surface 100f is a lower-side wall surface in the vertical direction of the vehicle 10. The sixth wall surface 100f is a wall surface corresponding to bottom walls of the main body 18b and the housing 18a and opposed to the fifth wall surface 100e.

The engine 12 is disposed on the first wall surface 100a. That is, when being installed in the vehicle 10, the engine 12 is located on one of opposite sides of the drive casing 100 that are opposite to each other in the horizonal direction.

The first electrical casing 102 and the second electrical casing 104 are separately disposed on respective two of the second wall surface 100b, the third wall surface 100c, the fourth wall surface 100d, the fifth wall surface 100e and the sixth wall surface 100f. For example, the first electrical casing 102 is disposed on the fifth wall surface 100e. That is, when being installed in the vehicle 10, the first electrical casing 102 is located adjacent to and on an upper side of the drive casing 100 in the vertical direction. Further, the second electrical casing 104 is disposed on the second wall surface 100b. That is, when being installed in the vehicle 10, the second electrical casing 104 is located adjacent to the drive casing 100 and on one of both sides of the drive casing 100 that is remote from the engine 12.

The first resolver 80 is provided for the first electric motor MG1 in the drive casing 100. The second resolver 82 is provided for the second electric motor MG2 in the drive casing 100. The current sensor 84 is housed in the first electrical casing 102. The first wire 86 and the second wire 88 are located only within the drive casing 100 and the first electrical casing 102. The first resolver 80 is located on one of opposite sides of the first electric motor MG1, which are opposite to each other in a direction parallel to the first axis CL1. The current sensor 84 is located on the other of the opposite sides of the first electric motor MG1, which are opposite to each other in the direction parallel to the first axis CL1. The second resolver 82 is located on one of opposite sides of the second electric motor MG2, which are opposite to each other in a direction parallel to the third axis CL3. The current sensor 84 is located on the other of the opposite sides of the second electric motor MG2, which are opposite to each other in the direction parallel to the third axis CL3.

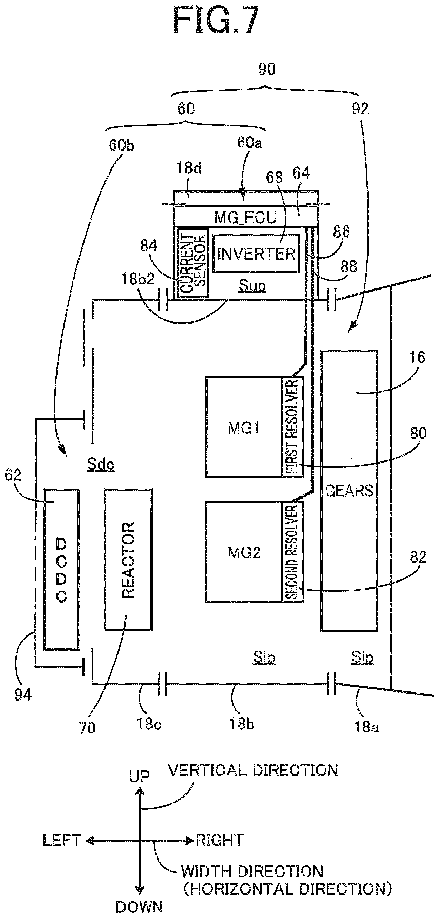

FIG.7 is a view as seen from a rear side of the vehicle 10, showing, by way of examples, positions of respective components of the mechanical-electrical integrated unit 90, wherein the positions of the respective components are different from those shown in FIGS. Particularly, the second electrical equipment 60b is arranged in an example shown in FIG.7, differently from an example shown in FIG.5. In the example shown in FIG. 5, the DC-DC converter 62 and the reactor 70 of the second electrical equipment 60b are arranged side by side in the vertical direction in the DC-DC space Sdc of the cover 18c. On the other hand, in the example shown in FIG.7, the DC-DC converter 62 and the reactor 70 of the second electrical equipment 60b are arranged side by side in the horizontal direction in the DC-DC space Sdc of the cover 18c.

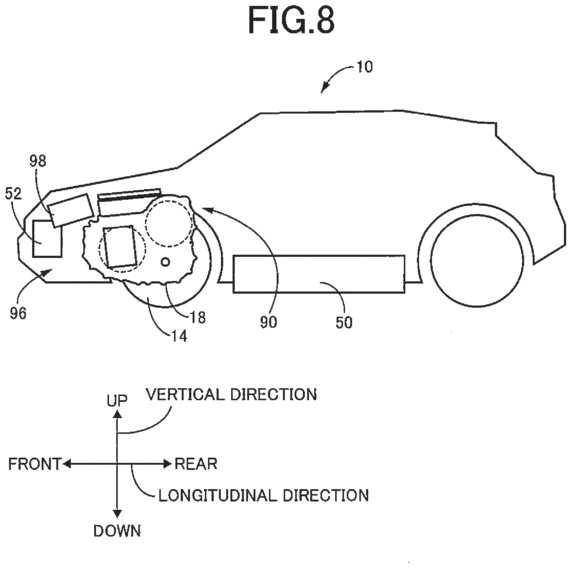

FIG.8 is a view showing, by way of example, a state in which the mechanical-electrical integrated unit 90 is installed in the vehicle 10. As shown in FIG.8, the mechanical-electrical integrated unit 90 is housed in an engine room 96 of the vehicle 10. The engine room 96 is synonymous with an engine compartment, which is a power source room housing the power sources. In the engine room 96, the auxiliary battery 52 and an air cleaner 98 are housed, for example. The high-voltage battery 50 is disposed on a lower side of a passenger compartment of the vehicle 10.

As described above, in the present embodiment, the engine 12 is disposed on the first wall surface 100a. Further, the first electrical casing 102 and the second electrical casing 104 are disposed separately on respective two of the second wall surface 100b, third wall surface 100c, fourth wall surface 100d, fifth wall surface 100e and sixth wall surface 100f. Owing to the arrangements, it is easy to install the mechanical-electrical integrated unit 90 in the vehicle 10, since the first electrical casing 102 and the second electrical casing 104 are arranged separately. Further, since the first electrical casing 102 and second electrical casing 104 are located to be distant from the engine 12, the first electrical equipment 60a and the second electrical equipment 60b are restricted from receiving heat from the engine 12. This allows for greater freedom in installing the mechanical-electrical integrated unit 90 while preventing deterioration of cooling performance.

In the present embodiment, when being installed in the vehicle 10, the engine 12 is disposed adjacent to the drive casing 100 in the horizontal direction. Further, when being installed in the vehicle 10, the first electrical casing 102 is disposed on the upper side of the drive casing 100 in the vertical direction. Further, when being installed in the vehicle 10, the second electrical casing 104 is disposed on one of opposite sides of the drive casing 100 which is remote from the engine 12. Owing to the arrangements, it is easy to appropriately install the mechanical-electrical integrated unit 90 in the vehicle 10, and it is possible to appropriately restrict the first electrical equipment 60a and the second electrical equipment 60b from receiving the heat from the engine 12.

In the present embodiment, the first electrical equipment 60a includes the inverter 68, and the second electrical equipment 60b includes the DC-DC converter 62. Owing to the arrangements, the inverter 68 and the DC-DC converter 62 are disposed separately, so that each of the first and second electric motors MG1, MG2 and the inverter 68 can be easily connected to each other, and maintenance performance of the DC-DC converter 62 can be improved.

In the present embodiment, the second electrical equipment 60b further includes the reactor 70. Owing to the arrangement, the inverter 68 and the reactor 70 are disposed separately, so that maintenance performance of the reactor 70 can be improved.

In the present embodiment, the first electrical equipment 60a further includes the electric-motor control device 64, and the current sensor 84 is housed in the first electrical casing 102. Owing to the arrangements, the current sensor 84 and the electric-motor control device 64 can be connected directly to each other, and the current sensor 84 and each of the first and second electric motors MG1, MG2 can be connected directly to each other, thereby making it possible to eliminate a terminal block and to suppress cost of the mechanical-electrical integrated unit 90.

In the present embodiment, the first electrical equipment 60a further includes the electric-motor control device 64. Further, the first resolver 80 is provided in the first electric motor MG1 housed in the drive casing 100, and the second resolver 82 is provided in the second electric motor MG2 housed in the drive casing 100. Moreover, each of the first and second wires 86, 88 is disposed only within the drive casing 100 and within the first electrical casing 102. Owing to the arrangements, the cost of the mechanical-electrical integrated unit 90 can be reduced because length of each of the first and second wires 86, 88 can be shortened as compared to an arrangement in which each of the first and second wires 86, 88 is routed outside the drive casing 100.

In the present embodiment, the first electrical equipment 60a further includes the electric-motor control device 64. Further, the current sensor 84 is housed in the first electrical casing 102. Further, the first resolver 80 is provided in the first electric motor MG1 housed in the drive casing 100, and the second resolver 82 is provided in the second electric motor MG2 housed in the drive casing 100. Further, the first resolver 80 is disposed on one of opposite sides of the first electric motor MG1 that are opposite to each other in the direction parallel to the first axis CL1, while the current sensor 84 is disposed on the other of the opposite sides of the first electric motor MG1 in the direction parallel to the first axis CL1. Further, the second resolver 82 is disposed on one of opposite sides of the second electric motor MG2 that are opposite to each other in the direction parallel to the third axis CL3, while the current sensor 84 is disposed on the other of the opposite sides of the second electric motor MG2 in the direction parallel to the third axis CL3. Owing to the arrangements, the current sensor 84 and the electric-motor control device 64 can be connected directly to each other, and the current sensor 84 and each of the first and second electric motors MG1, MG2 can be connected directly to each other. Further, each of the first and second wires 86, 88 can be easily disposed only within the drive casing 100 and within the first electrical casing 102.

There will be described other embodiments of this invention. The same reference signs as used in the above-described first embodiment will be used in the following embodiments, to identify the functionally corresponding elements, and descriptions thereof are not provided.

### SECOND EMBODIMENT

In the above-described first embodiment, the electric vehicle 10 is a hybrid electric vehicle provided with the engine 12, the first electric motor MG1 and the second electric motor MG2. In this second embodiment, there will be described an electric vehicle 200 as an example of the electric vehicle, wherein the electric vehicle 200 (hereinafter simply referred to as "vehicle 200") is provided with an electric motor MG

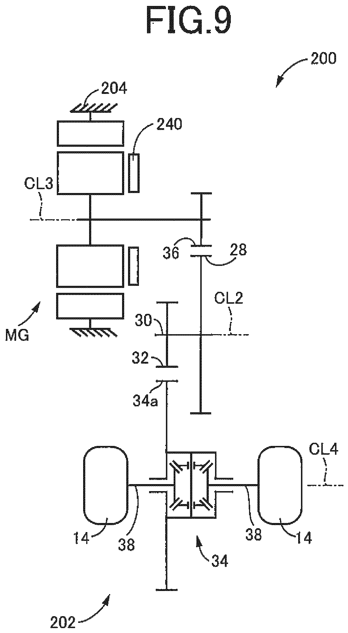

FIG.9 is a view showing, by way of example, a construction of the vehicle 200 to which the present invention is applied. As shown in FIG.9, the vehicle 200 is the electric vehicle provided with the electric motor MG The vehicle 200 is different from the vehicle 10 of the above-described first embodiment mainly in that the vehicle 200 is not provided with the transmission portion 24 including the engine 12 and first electric motor MG1. Further, the electric motor MG of the vehicle 200 corresponds to the second electric motor MG2 of the vehicle 10. Like the vehicle 10, the vehicle 200 is provided with a power transmission device 202 to which the electric motor MG is connected in a power transmittable manner. The electric motor MG is the power source (e.g., main power source). The electric motor MG and the power transmission device 202 is provided in a casing 204.

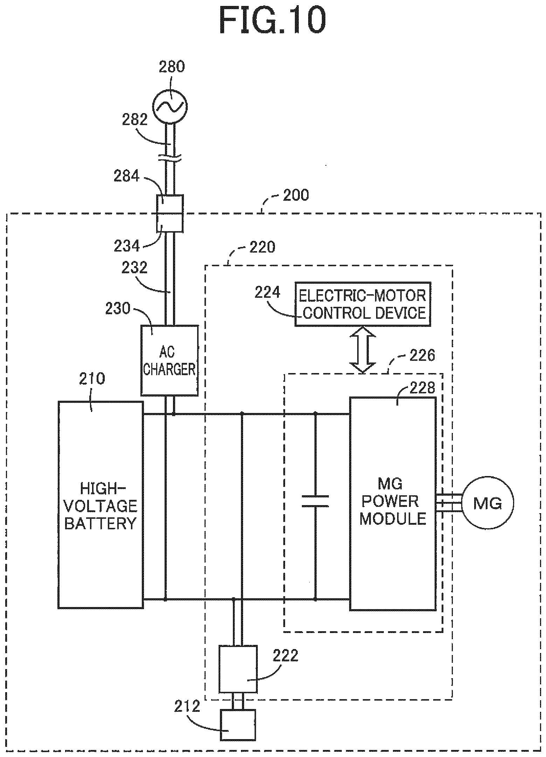

FIG. 10 is a view showing, by way of example, an electrical configuration for controlling the electric motor MG As shown in FIG. 10, the vehicle 200 further includes a high-voltage battery 210, an auxiliary battery 212, an electric-power control unit 220, an AC charger 230, an in-vehicle charging cable 232 and a charging inlet 234.

The high-voltage battery 210 is a chargeable and dischargeable DC power supply, and is connected to the electric-power control unit 220 and the AC charger 230.

The AC charger 230 is connected to the charging inlet 234 via the in-vehicle charging cable 232. The charging inlet 234 is provided in a body of the vehicle 200, such that the charging inlet 234 is connectable with a charging connector 284 of an external charging cable 282 that is connected to an external power source 280 as an external power source of the vehicle 200. The AC charger 230 is a charger that is configured to charge the high-voltage battery 210 with the electric power supplied from the external power source 280.

The electric-power control unit 220 includes a DC-DC converter 222, an electric-motor control device 224 and an inverter 226. The electric-power control unit 220 is an electric-power control apparatus that controls the electric power transmitted and received between the high-voltage battery 210 and the electric motor MG

The DC-DC converter 222 is connected to the high-voltage battery 210. The DC-DC converter 222 functions as a charging device that reduces a voltage of the high-voltage battery 210 to a voltage equivalent to a voltage of the auxiliary battery 212, and charges the auxiliary battery 212. The auxiliary battery 212 is a low-voltage battery that supplies the electric power for operating auxiliary devices, the electric-motor control device 224 and the like, which are provided in the vehicle 200.

The inverter 226 includes an MG power module 228 that includes switching elements. The inverter 226 converts the DC power supplied from the high-voltage battery 210, into the AC power, and then supplies the AC power to the electric motor MG The inverter 226 converts the AC current that is generated in the electric motor MG by regenerative braking, into the DC current. The electric-motor control device 224 controls the electric motor MG by controlling the inverter 226.

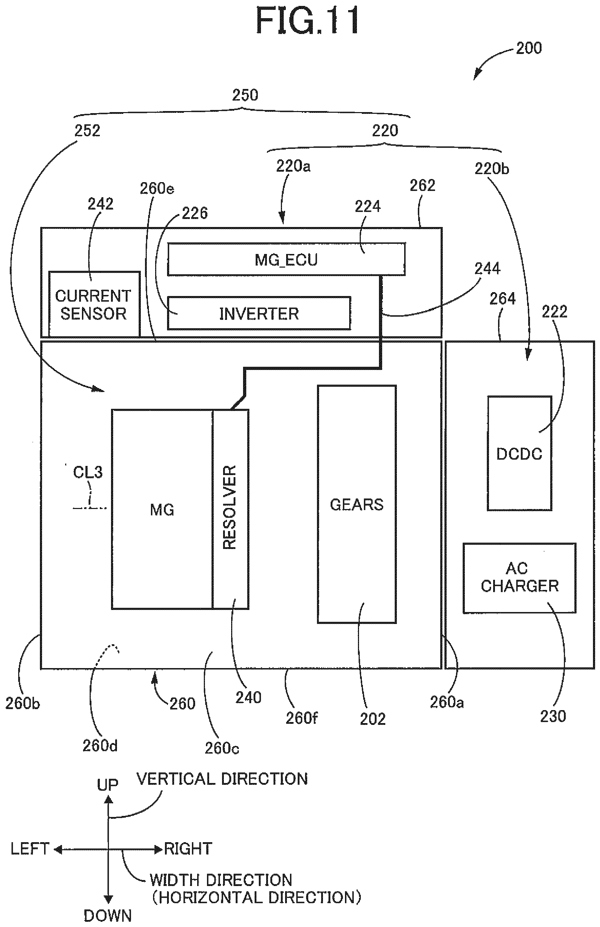

FIG. 11 is a view showing, by way of examples, positions of the respective casings of a mechanical-electrical integrated unit 250, as seen from a rear side of the vehicle 200. As seen in FIG. 11, the mechanical-electrical integrated unit 250 is constituted by a drive apparatus 252 and the electric-power control unit 220 that are integrally arranged. The drive apparatus 252 is a transaxle that includes the power transmission device 202 (28, 32, 34a, 36 etc.) and the electric motor MG, wherein the power transmission device 202 includes the driven gear 28, the final gear 32, the differential ring gear 34a and the reduction gear 36. The electric-power control unit 220 is sectioned into a first electrical equipment 220a and a second electrical equipment 220b. The first electrical equipment 220a includes the electric-motor control device 224 (see "MG_ECU" in FIG. 11) and the inverter 226, for example. The second electrical equipment 220b includes the DC-DC converter 222, for example.

The vehicle 200 further includes a resolver 240, a current sensor 242 and a wire 244. The resolver 240 detects a rotational speed of the electric motor MG, and supplies a signal indicative of the detected rotational speed, to the electric-motor control device 224. The current sensor 242 detects an electric current of the electric motor MG, and supplies a signal indicative of the detected electric current, to the electric-motor control device 224. The wire 244 electrically connects between the electric-motor control device 224 and the resolver 240.

The vehicle 200 includes a drive casing 260, a first electrical casing 262 and a second electrical casing 264. The drive casing 260 is a casing having a space that houses the drive apparatus 252. The first electrical casing 262 is a casing having a space that houses the first electrical equipment 220a. The second electrical casing 264 is a casing having a space that houses the second electrical equipment 220b. The mechanical-electrical integrated unit 250 is a unit in which the drive casing 260, the first electrical casing 262 and the second electrical casing 264 are integrally arranged. The casing 204 can be regarded to be constituted by the drive casing 260, the first electrical casing 262 and the second electrical casing 264 that are integrally arranged.

The drive casing 260 has a first wall surface 260a, a second wall surface 260b, a third wall surface 260c, a fourth wall surface 260d, a fifth wall surface 260e and a sixth wall surface 260f that cooperate to define a space that houses the drive apparatus 252. The first wall surface 260a is a right-side wall surface in the width direction of the vehicle 200. The second wall surface 260b is a left-side wall surface in the width direction of the vehicle 200, and is a wall surface opposed to the first wall surface 260a. The third wall surface 260c is a rear-side wall surface in the longitudinal direction of the vehicle 200. The fourth wall surface 260d is a front-side wall surface in the longitudinal direction of the vehicle 200, and is a wall surface opposed to the third wall surface 260c. The fifth wall surface 260e is an upper-side wall surface in the vertical direction of the vehicle 200. The sixth wall surface 260f is a lower-side wall surface in the vertical direction of the vehicle 200, and is a wall surface opposed to the fifth wall surface 260e.

The second electrical casing 264 is disposed on the first wall surface 260a that is located on one of both sides of the power transmission device 202, which is remote from the electric motor MG When being installed in the vehicle 200, the second electrical casing 264 is located on one of the both sides of the power transmission device 202, which is remote from the electric motor MG, and is located to be adjacent to the drive casing 260 in the horizontal direction.

The first electrical casing 262 is disposed on one of four wall surfaces which are four of the second wall surface 260b, third wall surface 260c, fourth wall surface 260d, fifth wall surface 260e and sixth wall surface 260f and which are other than the second wall surface 260b that is located on one of both sides of the power transmission device 202 which is a side of the electric motor MG For example, the first electrical casing 262 is disposed on the fifth wall surface 260e as the above-described one of the four wall surfaces. That is, when being installed in the vehicle 200, the first electrical casing 262 is adjacent to the drive casing 260 and is located on an upper side of the drive casing 260 in the vertical direction.

The AC charger 230 is housed in one of the first electrical casing 262 and the second electrical casing 264. For example, the AC charger 230 is housed in the second electrical casing 264. However, the AC charger 230 may be housed in the first electrical casing 262 or may be disposed on an upper side of the first electrical casing 262 in the vertical direction.

The resolver 240 is provided in the electric motor MG in the drive casing 260. The current sensor 242 is housed in the first electrical casing 262. The wire 244 is located only within the drive casing 260 and within the first electrical casing 262. The resolver 240 is located on one of opposite sides of the electric motor MG that are opposite to each other in a direction parallel to the third axis CL3. The current sensor 242 is located on the other of the opposite sides of the electric motor MG that are opposite to each other in the direction parallel to the third axis CL3.

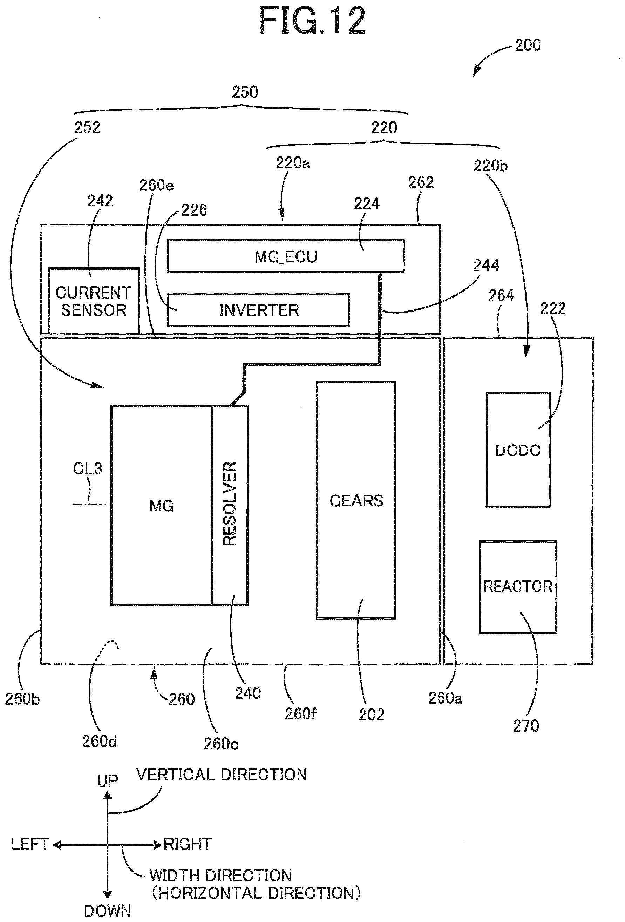

FIG. 12 is a view showing, by way of examples, positions of respective components of the mechanical-electrical integrated unit 250, wherein the positions of the respective components are different from those shown in FIG. 11. The positions of the respective components shown in FIG. 12 are different from those shown in FIG. 11, in that the AC charger 230 is not housed in the second electrical casing 264. For example, like the above-described electric-power control unit 60, where the electric-power control unit 220 is provided with a boost converter (not shown) that includes a reactor 270, the reactor 270 is housed in the second electrical casing 264, and the reactor 270 is included in the second electrical equipment 220b. In this case, the AC charger 230 is located on an upper side of the first electrical casing 262 in the vertical direction, for example.

As described above, in the present second embodiment, the second electrical casing 264 is disposed on the first wall surface 260a that is located on one of the both sides of the power transmission device 202 which is remote from the electric motor MG Further, the first electrical casing 262 is disposed on one of four wall surfaces which are the third wall surface 260c, the fourth wall surface 260d, the fifth wall surface 260e and the sixth wall surface 260f, and which other than the second wall surface 260b that is located on one of the both sides of the power transmission device 202 which is a side of the electric motor MG Owing to the arrangements, it is easy to install the mechanical-electrical integrated unit 250 in the vehicle 200, since the first electrical casing 262 and the second electrical casing 264 are arranged separately. Further, since the first electrical casing 262 and second electrical casing 264 are located to be distant from the electric motor MG, the first electrical equipment 220a and second electrical equipment 220b are restricted from receiving heat from the electric motor MG. This allows for greater freedom in installing the mechanical-electrical integrated unit 250 while preventing deterioration of cooling performance.

In the present second embodiment, when being installed in the vehicle 200, the second electrical casing 264 is disposed on one of the opposite sides of the drive casing 260 which are opposite to each other in the horizontal direction, and the first electrical casing 262 is disposed on the upper side of the drive casing 260 in the vertical direction. Owing to the arrangements, it is easy to appropriately install the mechanical-electrical integrated unit 250 in the vehicle 200, and it is possible to appropriately restrict the first electrical equipment 220a and the second electrical equipment 220b from receiving the heat from the electric motor MG.

In the present second embodiment, the first electrical equipment 220a includes the inverter 226, and the second electrical equipment 220b includes the DC-DC converter 222. Owing to the arrangements, the inverter 226 and the DC-DC converter 222 are disposed separately, so that each of the electric motor MG and the inverter 226 can be easily connected to each other, and maintenance performance of the DC-DC converter 222 can be improved.

In the present second embodiment, the second electrical equipment 220b further includes the reactor 270. Owing to the arrangement, the inverter 226 and the reactor 270 are disposed separately, so that maintenance performance of the reactor 270 can be improved.

In the present second embodiment, the AC charger 230 is housed in one of the first electrical casing 262 and the second electrical casing 264. Owing to the arrangement, it is possible to effectively use installation space.

In the present second embodiment, the first electrical equipment 220a further includes the electric-motor control device 224, and the current sensor 242 is housed in the first electrical casing 262. Owing to the arrangements, the current sensor 242 and the electric-motor control device 224 can be connected directly to each other, and the current sensor 242 and the electric motor MG can be connected directly to each other, thereby making it possible to eliminate a terminal block and to suppress cost of the mechanical-electrical integrated unit 250.

In the present second embodiment, the first electrical equipment 220a further includes the electric-motor control device 224. Further, the resolver 240 is provided in the electric motor MG housed in the drive casing 260. Moreover, the wire 244 is disposed only within the drive casing 260 and within the first electrical casing 262. Owing to the arrangements, the cost of the mechanical-electrical integrated unit 250 can be reduced because length of the wire 244 can be shortened as compared to an arrangement in which the wire 244 is routed outside the drive casing 260.

In the present second embodiment, the first electrical equipment 220a further includes the electric-motor control device 224. Further, the current sensor 242 is housed in the first electrical casing 262. Further, the resolver 240 is provided in the electric motor MG housed in the drive casing 260. Further, the resolver 240 is disposed on one of opposite sides of the electric motor MG that are opposite to each other in the direction parallel to the third axis CL3, while the current sensor 242 is disposed on the other of the opposite sides of the electric motor MG in the direction parallel to the third axis CL3. Owing to the arrangements, the current sensor 242 and the electric-motor control device 224 can be connected directly to each other, and the current sensor 242 and the electric motor MG can be connected directly to each other. Further, the wire 244 can be easily disposed only within the drive casing 260 and within the first electrical casing 262.

### THIRD EMBODIMENT

In the above-described first embodiment, the electric vehicle 10 is a hybrid electric vehicle provided with the engine 12, the first electric motor MG1 and the second electric motor MG2. In this second embodiment, there will be described an electric vehicle 300 as an example of the electric vehicle, wherein the electric vehicle 300 (hereinafter simply referred to as "vehicle 300") is a parallel hybrid electric vehicle that includes an engine, an electric motor and a power transmission device configured to transmit a power of the engine and a power of the electric motor, to drive wheels.

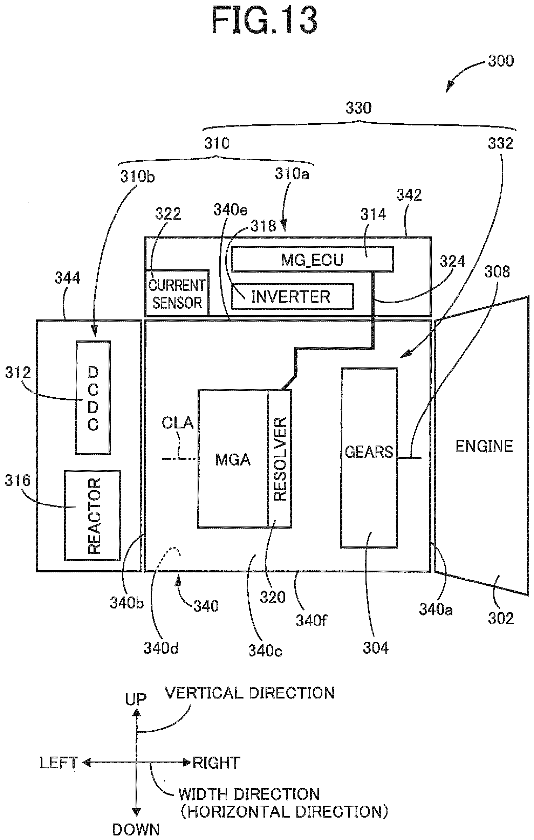

FIG. 13 is a view showing, by way of example, a construction of the vehicle 300, and showing, positions of respective components of a mechanical-electrical integrated unit 330 of the vehicle 300, as seen from a rear side of the vehicle 300.

As shown in FIG. 13, the vehicle 300 is provided with an engine 302, an assisting electric motor MGA and a power transmission device 304 to which the assisting electric motor MGA is connected in a power transmittable manner. The engine 302 is a power source (e.g., main power source) connected to the power transmission device 304 in a power transmittable manner. The assisting electric motor MGA is an electric motor serving as a power source (e.g., auxiliary power source) connected to the power transmission device 304 in a power transmittable manner. The assisting electric motor MGA and the power transmission device 304 are disposed in a casing 306.

Like the vehicle 10, the vehicle 300 has the electrical configuration for controlling the assisting electric motor MGA, for example. The vehicle 300 further includes an electric-power control unit 310. The electric-power control unit 310 includes a DC-DC converter 312, an electric-motor control device 314 (see "MG_ECU" in FIG. 13), a reactor 316 of a boost converter (not shown) and an inverter 318.

The mechanical-electrical integrated unit 330 is constituted by a drive apparatus 332 and the electric-power control unit 310 that are integrally arranged. The drive apparatus 332 is a transaxle that includes the power transmission device 304 and the assisting electric motor MGA. The electric-power control unit 310 is sectioned into a first electrical equipment 310a and a second electrical equipment 310b. The first electrical equipment 310a includes the electric-motor control device 314 and the inverter 318, for example. The second electrical equipment 310b includes the DC-DC converter 312 and the reactor 316, for example.

The vehicle 300 further includes a resolver 320, a current sensor 322 and a wire 244. The resolver 320 detects a rotational speed of the assisting electric motor MGA, and supplies a signal indicative of the detected rotational speed, to the electric-motor control device 314. The current sensor 322 detects an electric current of the assisting electric motor MGA, and supplies a signal indicative of the detected electric current, to the electric-motor control device 314. The wire 324 electrically connects between the electric-motor control device 314 and the resolver 320.

The vehicle 300 includes a drive casing 340, a first electrical casing 342 and a second electrical casing 344. The drive casing 340 is a casing having a space that houses the drive apparatus 332. The first electrical casing 342 is a casing having a space that houses the first electrical equipment 310a. The second electrical casing 344 is a casing having a space that houses the second electrical equipment 310b. The mechanical-electrical integrated unit 330 is a unit in which the drive casing 340, the first electrical casing 342 and the second electrical casing 344 are integrally arranged. The casing 306 can be regarded to be constituted by the drive casing 340, the first electrical casing 342 and the second electrical casing 344 that are integrally arranged.

The drive casing 340 has a first wall surface 340a, a second wall surface 340b, a third wall surface 340c, a fourth wall surface 340d, a fifth wall surface 340e and a sixth wall surface 340f that cooperate to define a space that houses the drive apparatus 332. The first wall surface 340a is a right-side wall surface in the width direction of the vehicle 300. The engine 302 is connected to an input shaft 308 of the power transmission device 304 on a side of the first wall surface 340a. The second wall surface 340b is a left-side wall surface in the width direction of the vehicle 300, and is a wall surface opposed to the first wall surface 340a. The third wall surface 340c is a rear-side wall surface in the longitudinal direction of the vehicle 300. The fourth wall surface 340d is a front-side wall surface in the longitudinal direction of the vehicle 300, and is a wall surface opposed to the third wall surface 340c. The fifth wall surface 340e is an upper-side wall surface in the vertical direction of the vehicle 300. The sixth wall surface 340f is a lower-side wall surface in the vertical direction of the vehicle 300, and is a wall surface opposed to the fifth wall surface 340e.

The engine 302 is disposed on the first wall surface 340a. That is, when being installed in the vehicle 300, the engine 302 is located to be adjacent to the drive casing 340 in the horizontal direction.

The first electrical casing 342 and the second electrical casing 344 are separately disposed on respective two of the second wall surface 340b, the third wall surface 340c, the fourth wall surface 340d, the fifth wall surface 340e and the sixth wall surface 340f. For example, the first electrical casing 342 is disposed on the fifth wall surface 340e. That is, when being installed in the vehicle 300, the first electrical casing 342 is located adjacent to and on an upper side of the drive casing 340 in the vertical direction. Further, the second electrical casing 344 is disposed on the second wall surface 340b. That is, when being installed in the vehicle 300, the second electrical casing 344 is located adjacent to the drive casing 340 and on one of both sides of the drive casing 340 that is remote from the engine 302.

The resolver 320 is provided in the assisting electric motor MGA in the drive casing 340. The current sensor 322 is housed in the first electrical casing 342. The wire 324 is located only within the drive casing 340 and within the first electrical casing 342. The resolver 320 is located on one of opposite sides of the assisting electric motor MG that are opposite to each other in a direction parallel to a rotation axis CLA of the assisting electric motor MGA. The current sensor 322 is located on the other of the opposite sides of the assisting electric motor MGA that are opposite to each other in the direction parallel to the rotation axis CLA.

As described above, in this third embodiment, it is possible to obtain substantially the same effects as in the above-described first embodiment.

While the preferred embodiments of this invention have been described in detail by reference to the drawings, it is to be understood that the invention may be otherwise embodied.

For example, in the above-described first embodiment, the second wall surface 100b and the fifth wall surface 100e are exemplified as wall surfaces on which the first electrical casing 102 and the second electrical casing 104 are disposed. However, the present invention is not limited to this arrangement, as long as the first electrical casing 102 and the second electrical casing 104 are disposed are separately disposed on respective two of the second wall surface 100b, the third wall surface 100c, the fourth wall surface 100d, the fifth wall surface 100e and the sixth wall surface 100f. The same descriptions may be applied to the above-described third embodiment, too.

In the above-described second embodiment, the first wall surface 260a and the fifth wall surface 260e are exemplified as wall surfaces on which the second electrical casing 264 and the first electrical casing 262 are disposed. However, the present invention is not limited to this arrangement, as long as the first electrical casing 262 is disposed on one of four wall surfaces which are four of the second wall surface 260b, third wall surface 260c, fourth wall surface 260d, fifth wall surface 260e and sixth wall surface 260f and which are other than the second wall surface 260b. Alternatively, the first electrical casing 262 may be disposed on the first wall surface 260a. In this case, the second electrical casing 264 may be disposed on one of four wall surfaces which are four of the second wall surface 260b, third wall surface 260c, fourth wall surface 260d, fifth wall surface 260e and sixth wall surface 260f and which are other than the second wall surface 260b. Thus, the first electrical casing 262 may be disposed on the first wall surface 260a, while the second electrical casing 264 may be disposed on the fifth wall surface 260e.

In the above-described first embodiment, the electric vehicle 10 may be a so-called plug-in-hybrid electric vehicle in which the high-voltage battery 50 is chargeable with an electric power supplied from an external power source. In this case, a charger, which is included in the vehicle 10, may be housed in one of the first electrical casing 102 and the second electrical casing 104. Alternatively, the charger may be disposed on an upper side of the first electrical casing 102 in the vertical direction. For example, where the electric-power control unit 60 is not provided with the boost converter 66 including the reactor 70, the charger may be housed in the second electrical casing 104. The same descriptions may be applied to the above-described third embodiment, too.

In the above-described first embodiment, the first resolver 80 may be disposed on one of both sides of the first electric motor MG1 which is remote from the power transmission device 16. Further, the second resolver 82 may be disposed on one of both sides of the second electric motor MG2 which is remote from the power transmission device 16. The same descriptions may be applied to the above-described second and third embodiments, too.

In the above-described first embodiment, the DC-DC plate 94 to which the second electrical equipment 60b is fixed is attached to the cover 18c. However, the present invention is not limited to this arrangement. For example, the second electrical equipment 60b may be fixed to a portion of the cover 18c which is on a side of the main body 18b. In this case, the DC-DC space Sdc is formed in the cover 18c, with the cover 18c being connected to the main body 18b.

Further, the electric vehicle, to which the present invention is applied, may be a series hybrid electric vehicle including: an engine; a driving electric motor serving as a power source; and an electric-power supplying electric motor which is connected to the engine in a power transmittable manner and which is configured to generate an electric power by a power of the engine. In such a series hybrid electric vehicle, the driving electric motor generates a power owing to the electric power generated by the power of the engine, so that the engine serves as a power source (e.g., main power source). Further, in such a series hybrid electric vehicle, a power transmission path between the engine and drive wheels may be selectively connected and disconnected by operation of a clutch.

In the above-described first embodiment, each of the first wall surface 100a, second wall surface 100b, third wall surface 100c, fourth wall surface 100d, fifth wall surface 100e and sixth wall surface 100f of the drive casing 100 has not be necessarily a flat surface. Each of the first wall surface 100a, second wall surface 100b, third wall surface 100c, fourth wall surface 100d, fifth wall surface 100e and sixth wall surface 100f may include a recessed or protruding portion, for example, as long as these wall surfaces 100a, 100b, 100c, 100d, 100e, 100f can form a space in which the drive apparatus 92 is housed. The same descriptions may be applied to the first wall surface 260a, second wall surface 260b, third wall surface 260c, fourth wall surface 260d, fifth wall surface 260e and sixth wall surface 260f in the above-described second embodiment. The same descriptions may be applied to the first wall surface 340a, second wall surface 340b, third wall surface 340c, fourth wall surface 340d, fifth wall surface 340e and sixth wall surface 340f in the above-described third embodiment.

In the above-described first embodiment, the current sensor 84 is housed in the first electrical casing 102 that has the space housing the first electrical equipment 60a including the electric-motor control device 64. However, the present invention is not limited to this arrangement. For example, the current sensor 84 may be housed in another casing other than a casing in which the electric-motor control device 64 is housed, and may be housed in the second electrical casing 104, for example. That is, the current sensor 84 may be housed in either the first electrical casing 102 or the second electrical casing 104. The same descriptions may be applied to the above-described second and third embodiments, too.

It is to be understood that the embodiments described above are given for illustrative purpose only, and that the present invention may be embodied with various modifications and improvements which may occur to those skilled in the art.

### NOMENCLATURE OF ELEMENTS

10: electric vehicle
12: engine
16: power transmission device
22: input shaft
50: high-voltage battery
52: auxiliary battery (low-voltage battery)
60a: first electrical equipment
60b: second electrical equipment
62: DC-DC converter
64: electric-motor control device
66: boost converter
68: inverter
70: reactor
80: first resolver (resolver)
82: second resolver (resolver)
84: current sensor
86: first wire (wire)
88: second wire (wire)
90: mechanical-electrical integrated unit
92: drive apparatus
100: drive casing
100a: first wall surface
100b: second wall surface
100c: third wall surface
100d: fourth wall surface
100e: fifth wall surface
100f: sixth wall surface
102: first electrical casing
104: second electrical casing
CL1: first axis (rotation axis of electric motor)
CL3: third axis (rotation axis of electric motor)
MG1: first electric motor (electric motor)
MG2: second electric motor (electric motor)
200: electric vehicle
202: power transmission device
210: high-voltage battery
212: auxiliary battery (low-voltage battery)
220a: first electrical equipment
220b: second electrical equipment
222: DC-DC converter
224: electric-motor control device
226: inverter
230: AC charger (charger)
240: resolver
242: current sensor
244: wire
250: mechanical-electrical integrated unit
252: drive apparatus
260: drive casing
260a: first wall surface
260b: second wall surface
260c: third wall surface
260d: fourth wall surface
260e: fifth wall surface
260f: sixth wall surface
262: first electrical casing
264: second electrical casing
270: reactor
280: external power source
MG: electric motor
300: electric vehicle
302: engine
304: power transmission device
308: input shaft
310a: first electrical equipment
310b: second electrical equipment
312: DC-DC converter
314: electric-motor control device
316: reactor
318: inverter
320: resolver
322: current sensor
324: wire
330: mechanical-electrical integrated unit
332: drive apparatus
340: drive casing
340a: first wall surface
340b: second wall surface
340c: third wall surface
340d: fourth wall surface
340e: fifth wall surface
340f: sixth wall surface
342: first electrical casing
344: second electrical casing
CLA: rotation axis (axis of electric motor)
MGA: assisting electric motor (electric motor)

## Claims

1. An electric vehicle (10;300) comprising:
an electric motor (MG1,MG2;MGA);
an engine (12;302);
a power transmission device (16;304) to which each of the electric motor (MG1,MG2;MGA) and the engine (12;302) is connected in a power transmittable manner;
first electrical equipment (60a;310a);
second electrical equipment (60b:310b);
a drive casing (100;340) that houses a drive apparatus (92;332) including the electric motor (MG1,MG2;MGA) and the power transmission device (16;304);
a first electrical casing (102;342) that houses the first electrical equipment (60a;310a); and
a second electrical casing (104;344) that houses the second electrical equipment (60b;310b), wherein
the drive casing (100;340), the first electrical casing (102;342) and the second electrical casing (104;344) are integrally arranged, and cooperate to constitute a mechanical-electrical integrated unit (90;330),
the drive casing (100;340) has a first wall surface (100a;340a), a second wall surface (100b;340b), a third wall surface (100c;340c), a fourth wall surface (100d;340d), a fifth wall surface (100e;340e) and a sixth wall surface (100f;340f) that cooperate to define a space in which the drive apparatus (92;332) is housed,
the engine (12;302) is disposed on the first wall surface (100a;340a), and is connected to an input shaft (22;308) of the power transmission device (16;304) on a side of the first wall surface (100a;340a), and
the first electrical casing (102;342) and the second electrical casing (104;344) are separately disposed on respective two of the second wall surface (100b;340b), the third wall surface (100c;340c), the fourth wall surface (100d;340d), the fifth wall surface (100e;340e) and the sixth wall surface (100f;340f).

2. The electric vehicle (10;300) according to claim 1, wherein
the engine (12;302) is disposed on one of opposite sides of the drive casing (100;340) which are opposite to each other in a horizontal direction of the electric vehicle (10;300),
one of the first electrical casing (102;342) and the second electrical casing (104;344) is disposed on the other of the opposite sides of the drive casing (100;340) in the horizontal direction, and
the other of the first electrical casing (102;342) and the second electrical casing (104;344) is disposed on an upper side of the drive casing (100;340) in a vertical direction of the electric vehicle (10;300).

3. An electric vehicle (200) comprising:
an electric motor (MG);
a power transmission device (202) to which the electric motor (MG) is connected in a power transmittable manner;
first electrical equipment (220a);
second electrical equipment (220b);
a drive casing (260) that houses a drive apparatus (252) including the electric motor (MG) and the power transmission device (202);
a first electrical casing (262) that houses the first electrical equipment (220a); and
a second electrical casing (264) that houses the second electrical equipment (220b), wherein
the drive casing (260), the first electrical casing (262) and the second electrical casing (264) are integrally arranged, and cooperate to constitute a mechanical-electrical integrated unit (250),
the drive casing (260) has a first wall surface (260a), a second wall surface (260b), a third wall surface (260c), a fourth wall surface (260d), a fifth wall surface (260e) and a sixth wall surface (260f) that cooperate to define a space in which the drive apparatus (252) is housed,
the first wall surface (260a) is located on one of both sides of the power transmission device (202) which is remote from the electric motor (MG),
the second wall surface (260b) is located on the other of the both sides of the power transmission device (202) which is a side of the electric motor (MG),
one of the first electrical casing (262) and the second electrical casing (264) is disposed on the first wall surface (260a), and
the other of the first electrical casing (262) and the second electrical casing (264) is disposed on one of the third wall surface (260c), the fourth wall surface (260d), the fifth wall surface (260e) and the sixth wall surface (260f).

4. The electric vehicle (200) according to claim 3, wherein
the one of the first electrical casing (262) and the second electrical casing (264) is disposed on one of opposite sides of the drive casing (260) which are opposite to each other in a horizontal direction of the electric vehicle (200), and
the other of the first electrical casing (262) and the second electrical casing (264) is disposed on an upper side of the drive casing (260) in a vertical direction of the electric vehicle (200).

5. The electric vehicle (10;200;300) according to any one of claims 1-4, further comprising a high-voltage battery (50;210) and a low-voltage battery (52;212), wherein
the first electrical equipment (60a;220a;310a) includes an inverter (68;226;318) that is configured to convert a DC power supplied from the high-voltage battery (50;210), into an AC power that is to be supplied to the electric motor (MG1,MG2;MG;MGA), and
the second electrical equipment (60b;220b;310b) includes a DC-DC converter (62;222;312) that is configured to lower a voltage of the high-voltage battery (50;210) to charge the low-voltage battery (52;212).

6. The electric vehicle (10;200;300) according to claim 5, wherein
the second electrical equipment (60b;220b;310b) further include a reactor (70;270;316) included in a boost converter (66) that is configured to boost the DC power supplied from the high-voltage battery (50;210) and to supply the boosted DC power to the inverter (68;226;318).

7. The electric vehicle (10;200;300) according to claim 5, further comprising a charger (230) that is configured to charge the high-voltage battery (50;210) with an electric power supplied from an external power source (280),
wherein the charger (230) is housed in one of the first electrical casing (102;262;342) and the second electrical casing (104;264;344).

8. The electric vehicle (10;200;300) according to claim 5, further comprising a current sensor (84;242;322) configured to detect an electric current of the electric motor (MG1,MG2;MG;MGA), wherein
the first electrical equipment (60a;220a;310a) further includes an electric-motor control device (64;224;314) configured to control the inverter (68;226;318), and
the current sensor (84;242;322) is configured to supply a signal indicative of the detected electric current of the electric motor (MG1,MG2;MG;MGA), to the electric-motor control device (64;224;314), and is housed in the first electrical casing (102;262;342).

9. The electric vehicle (10;200;300) according to claim 5, further comprising a resolver (80;82;240;320) configured to detect a rotational speed of the electric motor (MG1,MG2;MG;MGA), wherein
the first electrical equipment (60a;220a;310a) further includes an electric-motor control device (64;224;314) configured to control the inverter (68;226;318),
the resolver (80;82;240;320) is configured to supply a signal indicative of the detected rotational speed of the electric motor (MG1,MG2;MG;MGA), to the electric-motor control device (64;224;314), and is disposed in the electric motor (MG1,MG2;MG;MGA) housed in the drive casing (100;260;340), and
the electric-motor control device (64;224;314) and the resolver (80;82;240;320) are electrically connected through a wire (86,88;244;324) that is disposed only within the drive casing (100;260;340) and the first electrical casing (102;262;342).

10. The electric vehicle (10;200;300) according to claim 5, further comprising a current sensor (84;242;322) configured to detect an electric current of the electric motor (MG1,MG2;MG;MGA), and a resolver (80;82;240;320) configured to detect a rotational speed of the electric motor (MG1,MG2;MG;MGA), wherein
the first electrical equipment (60a;220a;310a) further includes an electric-motor control device (64;224;314) configured to control the inverter (68;226;318),
the current sensor (84;242;322) is configured to supply a signal indicative of the detected electric current of the electric motor (MG1,MG2;MG;MGA), to the electric-motor control device (64;224;314), and is housed in the first electrical casing (102;262;342),
the resolver (80;82;240;320) is configured to supply a signal indicative of the detected rotational speed of the electric motor (MG1,MG2;MG;MGA), to the electric-motor control device (64;224;314), and is disposed in the electric motor (MG1,MG2;MG;MGA) housed in the drive casing (100;260;340),
the resolver (80;82;240;320) is located on one of opposite sides of the electric motor (MG1,MG2;MG;MGA) that are opposite to each other in a direction parallel to an axis (CL1,CL3;CLA) of the electric motor (MG1,MG2;MG;MGA), and
the current sensor (84;242;322) is located on the other of the opposite sides of the electric motor (MG1,MG2;MG;MGA) in the direction parallel to the axis (CL1,CL3;CLA) of the electric motor (MG1,MG2;MG;MGA).
